# EUROPÄISCHE PATENTSCHRIFT

(11) **EP 1 056 194 B1**
(45) Veröffentlichungstag und Bekanntmachung des Hinweises auf die Patenterteilung: **12.04.2006**
(21) Anmeldenummer: 00201791.1
(22) Anmeldetag: 17.05.2000
(51) Int. Cl.: H03F 1/32, H03F 3/45

(54) **Transistorverstärker**
Transistor amplifier
Amplificateur à transistor

(30) Priorität: 26.05.1999 DE 19924107
(43) Veröffentlichungstag der Anmeldung: 29.11.2000
(73) Patentinhaber: Philips Intellectual Property & Standards GmbH, 20099 Hamburg (DE); Koninklijke Philips Electronics N.V., 5621 BA Eindhoven (NL)
(72) Erfinder: Dick, Burkhard, Philips Corp. Inteel. Prop. GmbH, 52064 Aachen (DE)
(74) Vertreter: Volmer, Georg

(56) Entgegenhaltungen:
- EP-A- 0 312 016
- US-A- 5 742 199
- PAN WU ET AL: "A CMOS OTA WITH IMPROVED LINEARITY BASED ON CURRENT ADDITION" PROCEEDINGS OF THE INTERNATIONAL SYMPOSIUM ON CIRCUITS AND SYSTEMS,US,NEW YORK, IEEE, Bd. CONF. 23, 1. Mai 1990 (1990-05-01), Seiten 2296-2299, XP000163663

## Beschreibung

Die Erfindung bezieht sich auf einen Transistorverstärker mit einem ersten Transistorpaar, das einen ersten und einen zweiten Transistor enthält, und mit einem zweiten Transistorpaar, das einen dritten und einen vierten Transistor enthält, worin die Emitteranschlüsse der Transistoren jedes Paares miteinander und mit je einer zugeordneten Konstantstromquelle gekoppelt sind, der Basis- und der Kollektor-Anschluß des ersten Transistors mit dem entsprechenden Anschluß des dritten Transistors und der Basis- und der Kollektor-Anschluß des zweiten Transistors mit dem entsprechenden Anschluß des vierten.Transistors gekoppelt ist, wobei den Basisanschlüssen des ersten und dritten Transistors einerseits und den Basisanschlüssen des zweiten und vierten Transistors andererseits ein Eingangssignal zuführbar ist und wobei aus den Kollektoranschlüssen der Transistoren ein Ausgangssignal ableitbar ist, und mit je einer in die Kopplung des Emitteranschlusses des ersten, zweiten, dritten bzw. vierten Transistors mit der zugeordneten Konstantstromquelle aufgenommenen ersten, zweiten, dritten bzw. vierten Gegenkopplungsanordnung.

In bipolarer Schaltungstechnik aufgebaute Differenzverstärker sind allgemein bekannt. Unter einem derartigen Differenzverstärker wird in der Regel eine spannungsgesteuerte Stromquelle verstanden, die mit zwei Transistoren aufgebaut ist, deren Emitteranschlüsse gemeinsam mit einer Konstantstromquelle verbunden sind. Die Basisanschlüsse der Transistoren bilden dann einen differentiellen Spannungseingang, die Kollektoranschlüsse stellen einen differentiellen Stromausgang dar. Als Übertragungsfunktion zwischen dem Ausgangsstrom und der Eingangsspannung ergibt sich ein Tangenshyperbolikus. Die Ableitung dieser Funktion nach der Eingangsspannung weist ein Maximum auf, wenn die Eingangsspannung Null wird. Die Abweichung dieser Ableitung vom Maximalwert ist ein Maß für den Linearitätsgrad des Differenzverstärkers. Für den beschriebenen, einfachen Differenzverstärker ergibt sich beispielsweise bei einer Aussteuerung mit einer Eingangsspannung von 15 mV (positiv oder negativ) eine Abweichung der Übertragungsfunktion von der Linearität von 7 %. Für eine fehlerarme Signalverarbeitung mit höheren Aussteuerungen ist ein derartiger Linearitätsgrad nicht ausreichend. Werden jedoch zur Erhöhung des Linearitätsgrades dem beschriebenen Differenzverstärker weitere Elemente hinzugefügt, erhöhen sich sowohl der Bauelementeaufwand als auch das Rauschen.

Der DE-OS 30 27 071 ist ein Transistorverstärker mit einem ersten Transistorpaar, das einen ersten und einen zweiten Transistor enthält, und mit einem Transistorpaar, das einen dritten und einen vierten Transistor enthält, bekannt. Dabei sind die Emitterelektroden der Transistoren jedes Paares miteinander verbunden. Zumindest für die Signalfrequenz sind außerdem die Basis- und die Kollektroelektrode des ersten Transistors mit der entsprechenden Elektrode des dritten Transistors und die Basis- und die Kollektorelektrode des zweiten Transistors mit der entsprechenden Elektrode des vierten Transistors gekoppelt. Die Basiselektrode des ersten bzw. dritten Transistors einerseits und die Basiselektrode des zweiten bzw. vierten Transistors andererseits sind mit je einer Klemme einer niederohmigen Signalquelle gekoppelt. Das Ausgangssignal des Transistorverstärkers ist aus den Kollektorströmen der Transistoren ableitbar. In die gemeinsamen Emitterzuleitungen der beiden Transistorpaare sind einander entsprechende Konstantstromquellen geschaltet. Die Transistoren sind so ausgebildet und/oder werden so betrieben, daß die Kollektorgleichströme durch den ersten und den vierten Transistor einander gleich und um einen zwischen 2 und 30 liegenden Faktor k größer oder kleiner als die einander gleichen Kollektorgleichströme durch den zweiten und den dritten Transistor sind. Dies wird insbesondere dadurch erreicht, daß der zweite und der dritte Transistor untereinander gleich sind und jeweils eine Emitterfläche haben, die um den Faktor k größer ist als die Emitterfläche der ebenfalls untereinander gleichen ersten und vierten Transistoren. Eine Vergrößerung der Emitterfläche um den Faktor k bewirkt die Vergrößerung des Emitter- bzw. des Kollektorgleichstromes durch den betreffenden Transistor um den Faktor k. Wird dabei der Faktor k gleich 4 gewählt, kann für einen gleichen Klirrfaktor dritter Ordnung die Eingangsspannung rund fünfrnal so groß gewählt werden wie die Eingangsspannung eines einzelnen Transistorpaares mit einer Konstantstromquelle in der gemeinsamen Emitterzuleitung, bei dem die Gleichströme durch die beiden Transistoren bzw. die Flächenverhältnisse gleich sind.

Außerdem ist es aus der DE-OS 30 27 071 bekannt, zwischen den Emitteranschlüssen der Transistorpaare unterteilte Widerstände zur Gegenkopplung anzuordnen und die Konstantstromquellen an die Widerstandsabgriffe anzuschließen. Zwar verursacht eine solche gegengekoppelte Schaltung größere Rauschsignale und hat eine kleinere Verstärkung, kann dafür aber auch große Signale linear verstärken.

Aus der EP 0 352 790 B1 ist ein Integratorschaltkreis bekannt, in dem emittergekoppelte Transistorenpaare angeordnet sind. In diesen Transistorenpaaren sind die Emitteranschlüsse der Transistoren über je eine in Flußrichtung gepolte Diode miteinander und mit Konstantstromquellen verbunden. Durch die Dioden wird der Aussteuerungsbereich des Eingangssignals unter Beibehaltung der Linearität des Integratorschaltkreises ungefähr auf das Zweifache erweitert verglichen mit einer Integratorschaltung ohne die genannten Dioden. Ebenso offenbart EP 0 312 014 eine solche Anordnung, wobei obenfalls der lineare Aussteuerbereich erweitert wird.

Aus der US-PS 3,855,541 ist es bekannt, daß eine Reihenschaltung aus einer bestimmten Anzahl als Dioden gekoppelter Transistoren mit je einer effektiven Emitterfläche der Größe m durch eine Transistorschaltung ersetzt werden kann, die eine Reihenschaltung aus der gleichen Anzahl von als Diode gekoppelten Transistoren umfaßt, deren effektive Emitterflächen jedoch um den Faktor m kleiner sind. Außerdem ist in dieser letztgenannten Schaltung der Reihenschaltung der Transistoren ein weiterer Transistor mit seiner Kollektor-Emitter-Strecke parallelgeschaltet; dessen effektive Emitterfläche (m-1)-mal so groß ist wie die effektive Emitterfläche jedes der Transistoren der durch den letztgenannten Transistor überbrückten Reihenschaltung. Vom letztgenannten Transistor ist außerdem ein Basisanschluß an den Basisanschluß desjenigen Transistors der Reihenschaltung geführt, der mit seinem Emitteranschluß mit dem Emitteranschluß des die Reihenschaltung überbrückenden Transistors verbunden ist.

Die Erfindung hat die Aufgabe, einen Transistorverstärker der eingangs genannten Art so auszubilden, daß mit geringem Schaltungsaufwand eine hohe Linearität und ein geringes Rauschen erreicht werden.

Erfindungsgemäß wird diese Aufgabe bei einem Transistorverstärker der gattungsgemäßen Art dadurch gelöst, daß
- der erste, zweite, dritte und vierte Transistor wenigstens nahezu übereinstimmende Emitterflächen aufweisen,
- die erste und vierte Gegenkopplungsanordnung je eine Reihenschaltung aus einer Anzahl n Diodenelemente umfassen, von denen jedes wenigstens weitgehend dem Basis-Emitter-Übergang des ersten bzw. vierten Transistors entspricht,
- die zweite und dritte Gegenkopplungsanordnung je eine einseitig mit dem Emitteranschluß des zweiten bzw. dritten Transistors gekoppelte Reihenschaltung aus einer Anzahl n-1 Diodenelemente umfassen, von denen jedes wenigstens weitgehend dem Basis-Emitter-Übergang des zweiten bzw. dritten Transistors entspricht,
- jede der Reihenschaltungen in der zweiten bzw. dritten Gegenkopplungsanordnung mit der zugeordneten Konstantstromquelle über einen Eingangszweig einer Stromspiegelanordnung verbunden ist,
- jeder der Eingangszweige einen Basis-Emitter-Übergang umfaßt, der wenigstens weitgehend dem Basis-Emitter-Übergang des zweiten bzw. dritten Transistors entspricht,
- jede der Stromspiegelanordnungen wenigstens einen Ausgangszweig umfaßt, der an ein Bezugspotential geführt ist,
- die Ausgangszweige Basis-Emitter-Übergänge aufweisen und
   die Basis-Emitter-Übergänge aller Ausgangszweige je einer der Stromspiegelanordnungen zusammengenommen eine Emitterfläche aufweisen, die einem durch eine Zahl m vorgegebenen Vielfachen der Emitterfläche des Basis-Emitter-Übergangs des Eingangszweigs dieser Stromspiegelanordnung entspricht.

Die Erfindung knüpft somit an die im Stand der Technik dargelegten Vorschläge an, eine Linearisierung eines Transistorverstärkers einerseits durch spiegelsymmetrische Kopplung zweier asymmetrischer Differenzverstärker zu erreichen oder andererseits einen Differenzverstärker durch als Gegenkopplungsanordnungen wirkende Emitterimpedanzen zu linearisieren, wobei die Emitterimpedanzen als Dioden ausgebildet sind. Es zeigt sich, daß die mit der erstgenannten Schaltungsanordnung gemäß DE 30 27 071 A1 erzielbare Linearisierung für die zu befriedigenden Anforderungen an die Linearität nicht ausreicht, was auch für die als Dioden ausgebildeten Gegenkopplungsanordnungen gemäß EP 0 352 790 B1 gilt. Eine Verstärkung der Gegenkopplung nach letztgenannter Druckschrift durch Reihenschaltung mehrerer Dioden in jeder Gegenkopplungsanordnung erhöht einerseits den Schaltungsaufwand und andererseits den Spannungsabfall in den Emitterzweigen des Differenzverstärkers, was insbesondere für niedrige Versorgungsspannungen problematisch wird. Außerdem vergrößert sich mit jedem zusätzlichen Diodenelement, d.h. Basis-Emitter-Übergang, das durch den Verstärker erzeugte Rauschen. Eine Verbesserung bezüglich des Rauschens und des Spannungsabfalls kann auch nicht dadurch erreicht werden, wenn eine Gegenkopplungsanordnung, die als Diodenkette ausgebildet ist, gemäß US PS 3,855,541 ersetzt wird. Dies würde allenfalls den Flächenbedarf der Gegenkopplungsanordnungen reduzieren.

Die Erfindung macht sich die Vorschläge der drei vorgenannten Druckschriften zum Stand der Technik zunutze, geht aber über deren reine Kombination entscheidend hinaus. Dabei wird der Transistorverstärker mit zwei asymmetrischen Differenzverstärkern verbunden mit Gegenkopplungsanordnungen in den Emitterzweigen, die Reihenschaltungen von Dioden aufweisen. Diese Reihenschaltungen von Dioden einschließlich der Transistoren der Transistorenpaare weisen jedoch alle nur geringe Emitterflächen auf. Dadurch wird einerseits Kristallfläche eingespart und andererseits mit wenigen in Reihe geschalteten Diodenelementen in den Gegenkopplungsanordnungen eine hohe Linearisierung erreicht. Die Ausgangsströme der in der zweiten bzw. dritten Gegenkopplungsanordnung in Anlehnung an den Vorschlag aus der US-PS 3,855,541 vorgesehenen Stromspiegelanordnungen werden nun erfindungsgemäß nicht in die Ausgangsströme des Transistorverstärkers einbezogen, sondern wenigstens teilweise, vorzugsweise aber vollständig, einem Bezugspotential zugeführt, welches vorteilhaft durch einen Versorgungsspannungsanschluß gebildet werden kann. Damit können die hierüber abgeführten Ströme keinen Einfluß mehr auf das Rauschen der Ausgangsströme des Transistorverstärkers ausüben. Durch die Erfindung wird somit ein rauscharmer Transistorverstärker mit geringem Schaltungsaufwand geschaffen, der eine hohe Linearität aufweist und auch für niedrige Versorgungsspannungen einsetzbar ist.

In einer vorteilhaften Ausgestaltung des erfindungsgemäßen Transistorverstärkers wird der Wert für die Zahl m auf wenigstens nahezu gleich 3 festgesetzt. Dies entspricht in seiner Auswirkung einem Flächenverhältnis der Emitterflächen der Transistoren der einzelnen Transistorenpaare von wenigstens nahezu 1:4. Damit wird eine besonders gute Linearität erhalten, da sich die nichtlinearen Signalanteile dritter Ordnung herausheben.

Transistorverstärker der erfindungsgemäßen Art sind bevorzugt einsetzbar in Geräten der elektrischen Nachrichtentechnik, in denen nur geringe Signalverfälschungen zulässig sind, beispielsweise für eine hochqualitative Audiosignalverarbeitung.

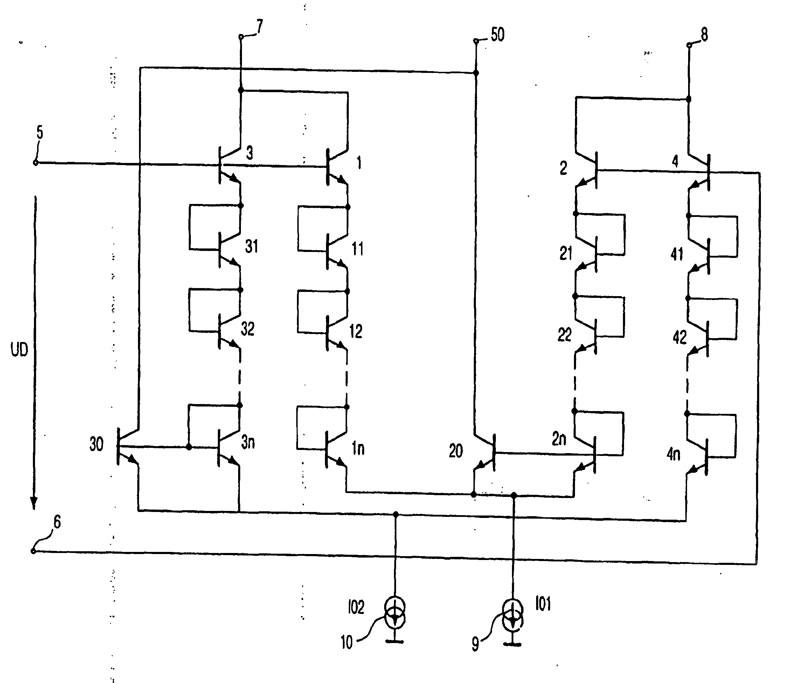

Die Figur zeigt ein Ausführungsbeispiel eines erfindungsgemäßen Transistorverstärkers. Dieser umfaßt einen ersten Transistor 1, einen zweiten Transistor 2, einen dritten Transistor 3 und einen vierten Transistor 4, wobei der erste und der zweite Transistor 1, 2 ein erstes Transistorenpaar bilden und entsprechend der dritte und der vierte Transistor 3, 4 zu einem zweiten Transistorenpaar zusammengefaßt sind. Basisanschlüsse des ersten und des dritten Transistors 1, 3 sind mit einem ersten Eingangsanschluß 5 verbunden. Basisanschlüsse des zweiten und des vierten Transistors 2, 4 sind mit einem zweiten Eingangsanschluß 6 verbunden. Zwischen den Eingangsanschlüssen 5, 6 wird als Eingangssignal eine Spannung DU zugeführt.

Die Kollektoranschlüsse des ersten und des dritten Transistors 1, 3 sind ferner mit einem ersten Ausgangsanschluß 7 verbunden. Entsprechend sind die Kollektoranschlüsse des zweiten und des vierten Transistors 2, 4 mit einem zweiten Ausgangsanschluß 8 verbunden. Aus den verbundenen Kollektoranschlüssen bzw. den Ausgangsanschlüssen 7, 8 ist dem Transistorverstärker im Betrieb ein Ausgangssignal ableitbar, wobei der erste Ausgangsanschluß 7 einen nichtinvertierenden Ausgang, der zweite Ausgangsanschluß 8 einen invertierenden Ausgang bildet.

Die Emitteranschlüsse der Transistoren 1, 2 bzw. 3, 4 der Transistorenpaare sind mit je einer Konstantstromquelle 9 bzw. 10 gekoppelt, wobei dem ersten Transistorenpaar 1, 2 eine erste dieser Konstantstromquellen mit dem Bezugszeichen 9 und dem zweiten Transistorenpaar 3, 4 die zweite Konstantstromquelle 10 zugeordnet ist. Die erste Konstantstromquelle 9 führt einen Gleichstrom 101, die zweite Konstantstromquelle 10 führt einen Gleichstrom 102.

In die Kopplung der Emitteranschlüsse der Transistoren 1, 2, 3, 4 mit den zugeordneten Konstantstromquellen 9 bzw. 10 ist je eine Gegenkopplungsanordnung aufgenommen. Eine erste dieser Gegenkopplungsanordnungen umfaßt eine Anzahl n Diodenelemente, von denen in der Figur diejenigen Diodenelemente mit den Bezugszeichen 11, 12 und 1n dargestellt sind. Die Diodenelemente 11, 12, 1n, deren Anzahl beliebig erweiterbar ist, sind zueinander in Reihe angeordnet und im vorliegenden Ausführungsbeispiel bevorzugt als zwischen ihrem Kollektoranschluß und ihrem Basisanschluß kurzgeschlossene Transistoren ausgebildet Entsprechend umfaßt eine zweite Gegenkopplungsanordnung zwischen dem Emitteranschluß des zweiten Transistors 2 und der ersten Konstantstromquelle 9 eine Reihenschaltung aus derselben Anzahl n Diodenelemente mit den Bezugszeichen 21, 22, 2n. Eine dritte Gegenkopplungsanordnung zwischen dem Emitteranschluß des dritten Transistors 3 und der zweiten Konstantstromquelle 10 umfaßt eine Reihenschaltung aus derselben Anzahl n Diodenelemente 31, 32, 3n. Die vierte der Gegenkopplungsanordnungen umfaßt eine Reihenschaltung aus wiederum n Diodenelementen 41, 42, 4n, die zwischen dem Emitteranschluß des vierten Transistors 4 und der zweiten Konstantstromquelle 10 angeordnet ist. In diesen Gegenkopplungsanordnungen entsprechen die jeweiligen Diodenelemente wenigstens weitgehend dem Basis-Emitter-Übergang des mit ihnen jeweils verbundenen ersten, zweiten, dritten bzw. vierten Transistors 1, 2, 3 bzw. 4. Vorzugsweise sind außerdem alle diese Diodenelemente bzw. Basis-Emitter-Übergänge wenigstens nahezu gleich ausgestaltet und weisen insbesondere wenigstens nahezu übereinstimmende Emitterflächen auf.

In den beschriebenen Reihenschaltungen der Diodenelemente in den Gegenkopplungsanordnungen können begrifflich auch die Diodenelemente 11, 21, 31, 41 als erste Dioden stufe, die Diodenelemente 12, 22, 32, 42 als zweite Diodenstufe usw. zusammengefaßt werden.

In der zweiten Gegenkopplungsanordnung bildet das Diodenelement 2n einen Eingangszweig einer Stromspiegelanordnung, deren Ausgangszweig durch einen Transistor 20 gebildet ist. Werden das Diodenelement 2n und der Transistor 20 als Stromspiegelanordnung begrifflich zusammengefaßt, können die übrigen Diodenelemente 21, 22, usw. begrifflich als eine Reihenschaltung aus einer Anzahl n-1 Diodenelemente zusammengefaßt werden. Diese Reihenschaltung von n-1 Diodenelementen ist dann einseitig mit dem Emitteranschluß des zweiten Transistors 2 gekoppelt und anderseitig mit dem Eingangszweig 2n der Stromspiegelanordnung 20, 2n.

Entsprechend umfaßt die dritte Gegenkopplungsanordnung einen Transistor 30 als Ausgangszweig einer Stromspiegelanordnung aus diesem Transistor 30 und dem Diodenelement 3n, wobei dann die Diodenelemente 31, 32, usw. eine Reihenschaltung aus n-1 Diodenelementen bilden.

In der Figur ist der Übersichtlichkeit halber sowohl für den Transistor 20 als auch für den Transistor 30 eine Ausführung mit einem einzigen Emitteranschluß und einem einzigen Kollektorsanschluß dargestellt worden. Im Gegensatz zu den Transistoren 1, 2, 3, 4 und den Diodenelementen 11, 12, usw. bis 4n, die alle als Transistoren mit wenigstens nahezu übereinstimmenden Emitterflächen ausgebildet sind, weisen die Transistoren 20, 30 eine Emitterfläche auf, die einem durch eine Zahl m vorgegebenen Vielfachen der Emirterfläche der Eingangszweige 2n und 3n der Stromspiegelanordnungen entspricht. Die Zahl m gibt somit das Spiegelverhältnis der Stromspiegelanordnungen 3n, 30 bzw. 2n, 20 an. Werden anstelle der Transistoren 20 bzw. 30 mehrfache Transistoren eingesetzt, beziffert die Zahl m das Verhältnis der Summe der Emitterflächen aller Transistoren, die zusammengenommen dem Transistor 20 bzw. 30 entsprechen, zur Emitterfläche des zugehörigen Eingangszweiges 2n bzw. 3n.

Im Ausführungsbeispiel ist der Emitteranschluß des Transistors 20 der zweiten Gegenkopplungsanordnung gemeinsam mit dem Emitteranschluß des Eingangszweiges 2n an die erste Konstantstromquelle 9 geführt. Entsprechend ist der Emitteranschluß des Transistors 30 mit dem Emitteranschluß des Eingangszweigs 3n mit der zweiten Konstantstromquelle 10 verbunden. Die Kollektoranschlüsse der Transistoren 20 und 30 sind gemeinsam mit einem Anschluß 50 verbunden, der ein Bezugspotential, vorzugsweise eine Versorgungsspannung, führt.
Im vorliegenden Transistorverstärker weisen somit bis auf die Ausgangszweige 20, 30 der Stromspiegelanordnungen alle Transistoren bzw. als Transistoren ausgebildeten Diodenelemente übereinstimmend kleine Emitterflächen auf, so daß ein geringer Flächenbedarf dieser Anordnung auf einem Halbleiterkristall gegeben ist. Durch die Transistoren 1, 2, 3, 4 sowie die Reihenschaltungen der Diodenelemente 11, 12 ... 4n fließen verhältnismäßig geringe Signalströme, und die aus diesen Schaltungsbauteilen den Ausgangsanschlüssen 7, 8 zufließenden Rauschsignale sind verhältnismäßig klein. Dagegen werden über die Ausgangszweige 20, 30 der Stromspiegelanordnungen die größeren Rauschanteile dem Anschluß 50 zugeführt.

In einer Abwandlung des dargestellten Ausführungsbeispiels des Transistorverstärkers, in der die Ausgangszweige 20, 30 als Mehrfachtransistoren bzw. als mehrfach parallel geschaltete Transistoren ausgebildet sind, können von diesen einzelne Kollektoranschlüsse an den Anschluß 50 und die übrigen Kollektoranschlüsse an die Ausgangsanschlüsse 7 bzw. 8 geführt sein. Damit werden die rauschbehafteten Ausgangsströme der Stromspiegelanordnungen nur teilweise dem Anschluß 50 zugeleitet, in ihren übrigen Teilen jedoch den Ausgangsströmen an den Ausgangsanschlüssen 7 bzw. 8 zugeschlagen. Dadurch stellt sich dort ein höheres Rauschen ein. Die in der Figur dargestellte Schaltungsvariante bildet somit bezüglich des angestrebten Rauschverhaltens ein Optimum.

Eine besonders günstige Linearisierung wird darüber hinaus erreicht, wenn die Zahl m wenigstens nahezu gleich 3 ist, wenn also die gesamte Emitterfläche des Transistors 20 dem Dreifachen der Emitterfläche des Eingangszweiges 2n entspricht, und wenn in gleicher Weise die Emitterfläche des Transistors 30 insgesamt dem Dreifachen der Emitterfläche des Eingangszweiges 3n entspricht.

## Patentansprüche

1. Transistorverstärker mit einem ersten Transistorpaar, das einen ersten (1) und einen zweiten (2) Transistor enthält, und mit einem zweiten Transistorpaar, das einen dritten (3) und einen vierten (4) Transistor enthält, worin die Emitteranschlüsse der Transistoren jedes Paares miteinander und mit je einer zugeordneten Konstantstromquelle (9, 10) gekoppelt sind, der Basis- und der Kollektor-Anschluß des ersten Transistors mir dem entsprechenden Anschluß des dritten Transistors und der Basis- und der Kollektor-Anschluß des zweiten Transistors mit dem entsprechenden Anschluß des vierten Transistors gekoppelt ist, wobei den Basisanschlüssen des ersten und dritten Transistors einerseits und den Basisanschlüssen des zweiten und vierten Transistors andererseits ein Eingangssignal (5, 6, UD) zuführbar ist und wobei aus den Kollektoranschlüssen der Transistoren ein Ausgangssignal ableitbar ist (7, 8), und mit je einer in die Kopplung des Emitteranschlusses des ersten, zweiten, dritten bzw. vierten Transistors mit der zugeordneten Konstantstromquelle aufgenommenen ersten, zweiten, dritten bzw. vierten Gegenkopplungsanordnung,
**dadurch gekennzeichnet, daß**
- der erste, zweite, dritte und vierte Transistor wenigstens nahezu übereinstimmende Emitterflächen aufweisen,
- die erste und vierte Gegenkopplungsanordnung je eine Reihenschaltung aus einer Anzahl n Diodenelemente umfassen (11, 12, ... 1n, 41, 42, ... 4n), von denen jedes wenigstens weitgehend dem Basis-Emitter-Übergang des ersten bzw. vierten Transistors entspricht,
- die zweite und dritte Gegenkopplungsanordnung je eine einseitig mit dem Emitteranschluß des zweiten bzw. dritten Transistors gekoppelte Reihenschaltung aus einer Anzahl n-1 Diodenelemente umfassen (31, 32, 21, 22), von denen jedes wenigstens weitgehend dem Basis-Emitter-Übergang des zweiten bzw. dritten Transistors entspricht,
- jede der Reihenschaltungen in der zweiten bzw. dritten Gegenkopplungsanordnung mit der zugeordneten Konstantstromquelle über einen Eingangszweig einer Stromspiegelanordnung(30, 3n, 20, 2n) verbunden ist,
- jeder der Eingangszweige einen Basis-Emitter-Übergang umfaßt, der wenigstens weitgehend dem Basis-Emitter-Übergang des zweiten bzw. dritten Transistors entspricht,
- jede der Stromspiegelanordnungen wenigstens einen Ausgangszweig umfaßt, der an ein Bezugspotential gerührt ist (50),
- die Ausgangszweige Basis-Emitter-Übergänge aufweisen und
- die Basis-Emitter-Übergänge aller Ausgangszwcige je einer der Stromspiegelanordnungen zusammengenommen eine Emitterfläche aufweisen, die einem durch eine Zahl m vorgegebenen Vielfachen der Emitterfläche des Basis-Emitter-Übergangs des Eingangszweigs dieser Stromspiegelanordnung entspricht.

2. Transistorverstärker nach Anspruch 1,
**dadurch gekennzeichnet,daß** die Zahl m wenigstens nahezu gleich 3 ist.

3. Gerät der elektrischen Nachrichtentechnik,
**gekennzeichnet durch** einen Transistorverstärker nach Anspruch 1 oder 2.

## Claims

1. A transistor amplifier having a first transistor pair, which comprises a first (1) and a second (2) transistor, and having a second transistor pair, which comprises a third (3) and a fourth (4) transistor, in which the transistors of each pair have their emitter electrodes coupled to each other and to an associated constant current source (9, 10), the first transistor has its base electrode and its collector electrode coupled to the corresponding electrodes of the third transistor, and the second transistor has its base electrode and its collector electrode coupled to the corresponding electrodes of the fourth transistor, the base electrodes of the first and the third transistor, on the one hand, and the base electrodes of the second and the fourth transistor, on the other hand, being arranged to receive an input signal (5, 6, UD) and an output signal (7, 8) being derivable from the collector electrodes of the transistors, and having a first, a second, a third and a fourth negative-feedback circuit each included in the coupling of the emitter electrodes of the first, the second, the third and the fourth transistor, respectively, to the associated constant current source, **characterized in that**
- the first, the second, the third and the fourth transistor have at least substantially equal emitter areas,
- the first and the fourth negative-feedback circuit each comprise a series arrangement of a plurality of n diode elements (11, 12,...1n, 41, 42,...4n), each of which is at least substantially similar to the base-emitter junction of the first transistor and the fourth transistor, respectively,
- the second and the third negative-feedback circuit each comprise a series arrangement of a plurality of n-1 diode elements (31, 32, 21, 22), each of which is at least substantially similar to the base-emitter junction of the second transistor and the third transistor, respectively, which series arrangements each have one end coupled to the emitter electrodes of the second transistor and the third transistor, respectively,
- each of the series arrangements in the second negative-feedback circuit and the third negative-feedback circuit, respectively, is connected to the associated constant current source via an input branch of a current mirror circuit (30, 3n, 20, 2n),
- each of the input branches comprises a base-emitter junction which is at least substantially similar to the base-emitter junction of the second transistor and the third transistor, respectively,
- each of the current mirror circuits comprises at least one output branch coupled to a reference potential (50),
- the output branches include base-emitter junctions, and
the base-emitter junctions of all the output branches of each time one of the current mirror circuits together have an emitter area which corresponds to a multiple, given by a number m, of the emitter area of the base-emitter junction of the input branch of this current mirror circuit.

2. A transistor amplifier as claimed in claim 1, **characterized in that** the number m is at least substantially equal to 3.

3. An electrical communication apparatus, **characterized by** a transistor amplifier as claimed in claim 1 or 2.

## Revendications

1. Amplificateur à transistor avec une première paire de transistors qui contient des premier (1) et deuxième (2) transistors et avec une deuxième paire de transistors qui contient des troisième (3) et quatrième (4) transistors, dans lequel les bornes d'émetteur des transistors de chaque paire sont couplées l'une à l'autre et avec une source de courant constant respectivement affectée (9,10), la borne de base et la borne de collecteur du premier transistor sont couplées à la borne correspondante du troisième transistor et la borne de base et la borne de collecteur du deuxième transistor sont couplées à la borne correspondante du quatrième transistor, un signal d'entrée (5, 6, UD) pouvant être amené aux bornes de base des premier et troisième transistors, d'une part, et aux bornes de base des deuxième et quatrième transistors, d'autre part et un signal de sortie (7, 8) pouvant être dérivé des bornes de collecteur des transistors et avec à chaque fois des premier, deuxième, troisième ou quatrième dispositifs de contre-réaction insérés dans le couplage de la borne d'émetteur des premier, deuxième, troisième et quatrième transistors avec la source de courant constant attribuée,
**caractérisé en ce**
- **que** les premier, deuxième troisième et quatrième transistors présentent des surfaces d'émetteur correspondantes, du moins presque;
- les premier et quatrième dispositifs de contre-réaction comprennent respectivement un montage en série d'un nombre n d'éléments de diode (11, 12, ..., 1n; 41, 42, ..., 4n) dont chacun correspond, du moins en grande partie, à la transition base-émetteur des premier ou quatrième transistors;
- les deuxième et troisième dispositifs de contre-réaction comprennent chacun un montage en série couplé unilatéralement avec la borne d'émetteur des deuxième ou troisième transistors à partir d'un nombre n-1 d'éléments de diode (31, 32, 21, 22) dont chacun correspond, du moins en grande partie, à la transition base-émetteur des deuxième ou troisième transistors,
- chacun des montages en série dans les deuxième et troisième dispositifs de contre-réaction est relié avec la source de courant constant affectée par l'intermédiaire d'une branche d'entrée d'un dispositif de miroir de courant (30, 3n, 20, 2n),
- chacune des branches d'entrée comprend une transition base-émetteur qui correspond, du moins en grande partie, à la transition base-émetteur des deuxième ou troisième transistors,
- chacun des dispositifs de miroir de courant comprend au moins une branche de sortie qui est guidée à un potentiel de référence (50),
- les branches de sortie présentent des transitions base-émetteur et
les transitions base-émetteur de toutes les branches de sortie réunies d'un dispositif de miroir de courant respectif présentent une surface d'émetteur qui correspond à un multiple prédéterminé par un nombre m de la surface d'émetteur de la transition base-émetteur de la branche d'entrée de ce dispositif de miroir de courant.

2. Amplificateur à transistor selon la revendication 1,
**caractérisé en ce**
**que** le nombre m est égal à 3, du moins presque.

3. Appareil de la technique électrique de communication,
**caractérisé par**
un amplificateur à transistor selon l'une des revendications 1 ou 2.
